(19)

Europäisches
Patentamt
European
Patent Office
Office européen
des brevets

(11)  EP 2 726 887 B1

(12)  **EUROPEAN PATENT SPECIFICATION**

(45) Date of publication and mention
of the grant of the patent:
**25.03.2015  Bulletin 2015/13**

(21) Application number: **11728853.0**

(22) Date of filing: **01.07.2011**

(51) Int Cl.:
*G01R 29/08* (2006.01)     *G01R 31/28* (2006.01)
*G01R 31/00* (2006.01)

(86) International application number:
**PCT/EP2011/061130**

(87) International publication number:
**WO 2013/004274 (10.01.2013 Gazette 2013/02)**

(54)  **DEVICE AND METHOD FOR EMI SOURCE LOCATION**

VORRICHTUNG UND VERFAHREN ZUR ORTUNG VON EMI-QUELLEN

DISPOSITIF ET PROCÉDÉ POUR LOCALISATION DE SOURCE EMI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.05.2014  Bulletin 2014/19**

(73) Proprietor: **Telefonaktiebolaget LM Ericsson
(PUBL)
164 83 Stockholm (SE)**

(72) Inventor: **SANDER, Sverker
S-427 36 Billdal (SE)**

(74) Representative: **Vejgaard, Christian
Ericsson AB
Patent Unit GL
Lindholmspiren 11
417 56 Göteborg (SE)**

(56) References cited:
EP-A2- 0 239 251     US-A- 4 939 446
US-A1- 2009 306 920     US-A1- 2010 177 538

• ATTAIANESE C ET AL: "Automatic Testing of the
EMI Due to the Switching Frequency of the PWM
Signal", IEEE TRANSACTIONS ON INDUSTRY
APPLICATIONS, IEEE SERVICE CENTER,
PISCATAWAY, NJ, US, vol. 44, no. 2, 1 March 2008
(2008-03-01), pages 644-649, XP011206324, ISSN:
0093-9994

• KASUGA T ET AL: "Quantitative estimation for
electromagnetic field noise from PCB with
switching transistor", 2003 IEEE
INTERNATIONAL SYMPOSIUM ON
ELECTROMAGNETIC COMPATIBILITY. EMC.
SYMPOSIUM RECORD. BOSTON, MA, AUG. 18 -
22, 2003; [INTERNATIONL SYMPOSIUM ON
ELECTROMAGNETIC COMPATIBILITY], NEW
YORK, NY : IEEE, US, vol. 1, 18 August 2003
(2003-08-18), pages 465-470, XP010660852, DOI:
10.1109/ISEMC.2003.1236642 ISBN:
978-0-7803-7835-3

• FORGHANI-ZADEH H P ET AL: "A lossless,
accurate, self-calibrating current-sensing
technique for DC-DC converters", INDUSTRIAL
ELECTRONICS SOCIETY, 2005. IECON 2005.
31ST ANNUAL CONFERENCE OF IEEE, IEEE,
PISCATAWAY, NJ, USA, 6 November 2005
(2005-11-06), pages 549-554, XP010875934, DOI:
10.1109/IECON.2005.1568964 ISBN:
978-0-7803-9252-6

• HERNANDO M M ET AL: "EMI Radiated Noise
Measurement System Using the Source
Reconstruction Technique", IEEE
TRANSACTIONS ON INDUSTRIAL
ELECTRONICS, IEEE SERVICE CENTER,
PISCATAWAY, NJ, USA, vol. 55, no. 9, 1
September 2008 (2008-09-01), pages 3258-3265,
XP011229791, ISSN: 0278-0046, DOI: 10.1109/TIE.
2008.928042

EP 2 726 887 B1

- MASUNAGA N ET AL: "A flexible EMI measurement sheet to measure electric and magnetic fields separately with distributed antennas and LSI's", ELECTROMAGNETIC COMPATIBILITY, 2009. EMC 2009. IEEE INTERNATIONAL SYMPOSIUM ON, IEEE, PISCATAWAY, NJ, USA, 17 August 2009 (2009-08-17), pages 156-160, XP031544921, ISBN: 978-1-4244-4266-9

## Description

TECHNICAL FIELD

The present invention discloses an electronics device with the ability to locate sources of electromagnetic interference, and also discloses a corresponding method.

BACKGROUND

Electromagnetic interference, EMI, may constitute a serious problem in an electronics device. Electromagnetic interference may cause the electronics device to malfunction, and may, in the case of the electromagnetic interference being generated internally, lead to the device being in non-compliance with requirements for electromagnetic compatibility, EMC. It is thus important to be able to locate sources of EMI.

Traditional methods for locating sources of EMI comprise measuring voltages or currents by manually connecting probes for such instruments as oscilloscopes and/or spectrum analyzers, or by measuring the electromagnetic field around an electronics device by connecting near field antenna probes to an oscilloscope or a spectrum analyzer.

The document ATTAIANESE C ET AL: "Automatic Testing of the EMI Due to the Switching Frequency of the PWM Signal", IEEE TRANSACTIONS ON INDUSTRY APPLICATIONS, IEEE SERVICE CENTER, PISCATAWAY, NJ, US, vol. 44, no. 2, 1 March 2008 (2008-03-01), pages 644-649, XP011206324, discloses an electronic device comprising at least a circuit board, a plurality of power converters arranged on said circuit boards, each power converter comprising one or more transducers for measuring a voltage or a current in the power converter, and a sub-system for locating sources of electromagnetic interference.

As can be understood, the traditional methods for locating sources of EMI are work-intensive, and are also difficult to use in locations which are difficult to access manually.

SUMMARY

It is an object of the invention to obviate at least some of the disadvantages of the traditional methods for locating sources of EMI in and around an electronics device.

This object is addressed by the invention in that it discloses an electronics device comprising one or more circuit boards, and a plurality of power converters arranged on one or more of the circuit boards. Each power converter comprises one or more transducers for measuring a voltage or a current in the power converter.

The electronics device additionally comprises a sub-system for locating sources of electromagnetic interference. In the electronics device, the transducers of two or more of the power converters are also connected to the sub-system for locating sources of electromagnetic interference in order to supply it with measurement data, and the sub-system for locating sources of electromagnetic interference is arranged to use the measurement data from the transducers in order to locate sources of electromagnetic interference.

Thus, since the electronics device of the invention utilizes transducers of power converters which are already present in the electronics device, a large degree of simplification is achieved, as well as obtaining cost-efficiency. In addition, the difficulties of manually accessing measuring points in an electronics device are also obviated by means of the invention.

In embodiments of the electronics device, the power converters use Analogue to Digital Converters, ADCs, as their transducers.

In embodiments of the electronics device, the measured voltage or current in the power converter is also used as an output voltage or current from the power converter.

In embodiments of the electronics device, at least one of the power converters is a DC-DC converter.

In embodiments of the electronics device, at least one of said power converters is an AC-DC converter.

In embodiments of the electronics device, at least one of said power converters is an AC-AC converter.

In embodiments of the electronics device, the transducers are arranged to continuously supply the measurement data to the sub-system for locating sources of electromagnetic interference.

In embodiments of the electronics device, the transducers are arranged to supply a time limited segment of said measurement data at discrete points in time to the sub-system for locating sources of electromagnetic interference. In some such embodiments of the electronics device, the sub-system for locating sources of electromagnetic interference is arranged to control the discrete points in time at which the transducers supply said measurement data.

In embodiments of the electronics device, the transducers are arranged to include a timestamp with each time limited segment of measurement data, signifying when the measurement was made.

In embodiments, the electronics device is equipped with a list of where the transducers are located in the electronics device, for use in locating sources of electromagnetic interference.

In embodiments, the electronics device is equipped with a list of how power terminals of the power converters are electrically connected to each other, for use in locating sources of electromagnetic interference.

In embodiments of the electronics device, the location of a source of electromagnetic interference is determined by weighing amplitude signals in said measurement data by their corresponding transducer's location.

The invention also discloses a method for use in an electronics device, comprising receiving measurement data on voltage and/or current from one or more transducers in one or more power converters on one or more circuit boards in the electronics device. According to the method, the measurement data is used in order to locate sources of electromagnetic interference.

In embodiments of the method, the power converters use Analogue to Digital Converters as their transducers.

In embodiments of the method, at least one of the power converters is a DC-DC converter.

In embodiments of the method, at least one of the power converters is an AC-DC converter.

In embodiments of the method, at least one of the power converters is an AC-AC converter.

In embodiments of the method, the measurement data is continuously supplied from said transducers.

In embodiments of the method, the measurement data is supplied during a time limited segment at discrete points in time.

In embodiments of the method, a timestamp is included from the transducers with each time limited segment of measurement data, signifying when the measurement was made.

In embodiments of the method, a timestamp is attached to each received measurement data.

In embodiments of the method, the locations of the transducers in the electronics device are used for locating sources of electromagnetic interference.

BRIEF DESCRIPTION OF THE DRAWINGS

The invention will be described in more detail in the following, with reference to the appended drawings, in which

> Figs 1 and 2 show embodiments of a power converter, and
> Figs 3-5 show examples of electronic devices with multiple power converters, and
> Fig 6 shows a schematic block diagram of a subsystem for locating sources of electromagnetic interference, and
> Fig 7 shows a principle for use in the invention, and
> Fig 8 shows a flowchart of a method.

DETAILED DESCRIPTION

Embodiments of the present invention will be described more fully hereinafter with reference to the accompanying drawings, in which embodiments of the invention are shown. The invention may, however, be embodied in many different forms and should not be construed as being limited to the embodiments set forth herein. Like numbers in the drawings refer to like elements throughout.

The terminology used herein is for the purpose of describing particular embodiments only, and is not intended to limit the invention.

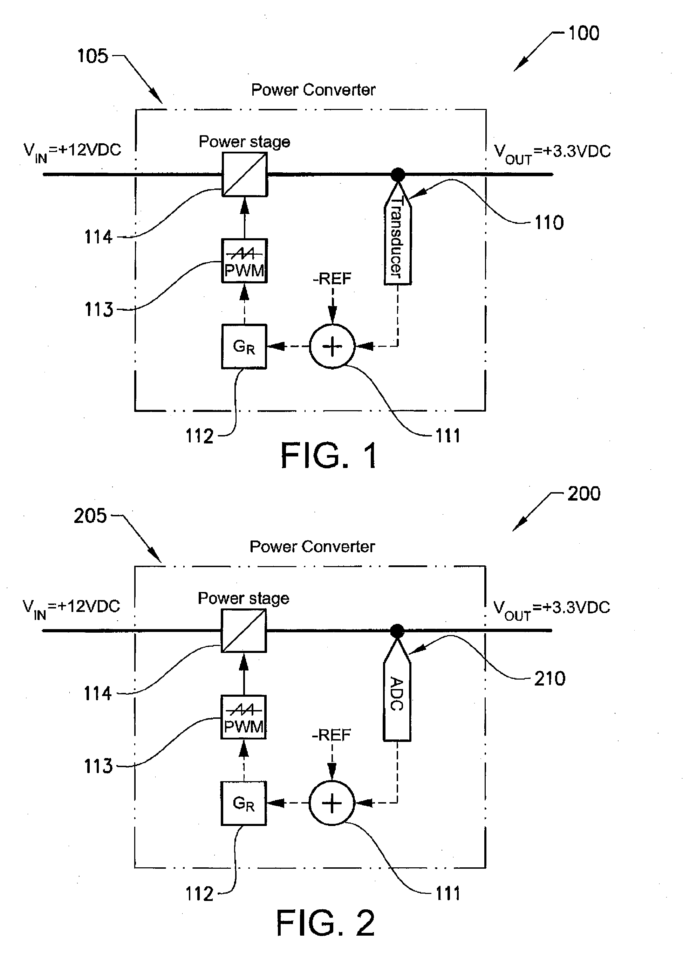

As mentioned initially in this text, the electronics device utilizes a plurality of power converters. For this reason, a power converter will be briefly described with reference to figs 1 and 2. The power converter shown in those two figs is a DC-DC converter, which is however merely one example of a power converter which can be used in the electronics device of the invention. Other kinds of power converters which can be used in the invention include AC-DC converters and AC-AC converters.

Thus, fig 1 shows an embodiment of a power converter 105 for use in an electronics device. The power converter comprises a transducer 110 for measuring a voltage or a current in the power converter 105. This voltage or current is, for example, either an internal voltage or current in the power converter, or it can be a voltage or current which is produced in the power converter and then used as an output voltage or current from the power converter. The latter is the case in the embodiment 105 shown in fig 1, i.e. the transducer 110 measures a voltage which is used as output voltage $V_{OUT}$ from the power converter 105. In the example of fig 1, the transducer 110 is part of a control loop in the power converter 105, and thus outputs its measured values to a comparator 111, which compares the value measured by the transducer 110 to an accurate reference value shown as REF in fig 1. The difference between the transducer's measured value and the accurate reference value is used by a regulator $G_R$ 112 whose output signal is then used by a Pulse Width Modulator, PWM 113, and a power stage 114.

In embodiments, one of which is shown in fig 2, the transducer 110 is an Analogue to Digital Converter, an ADC, 210.

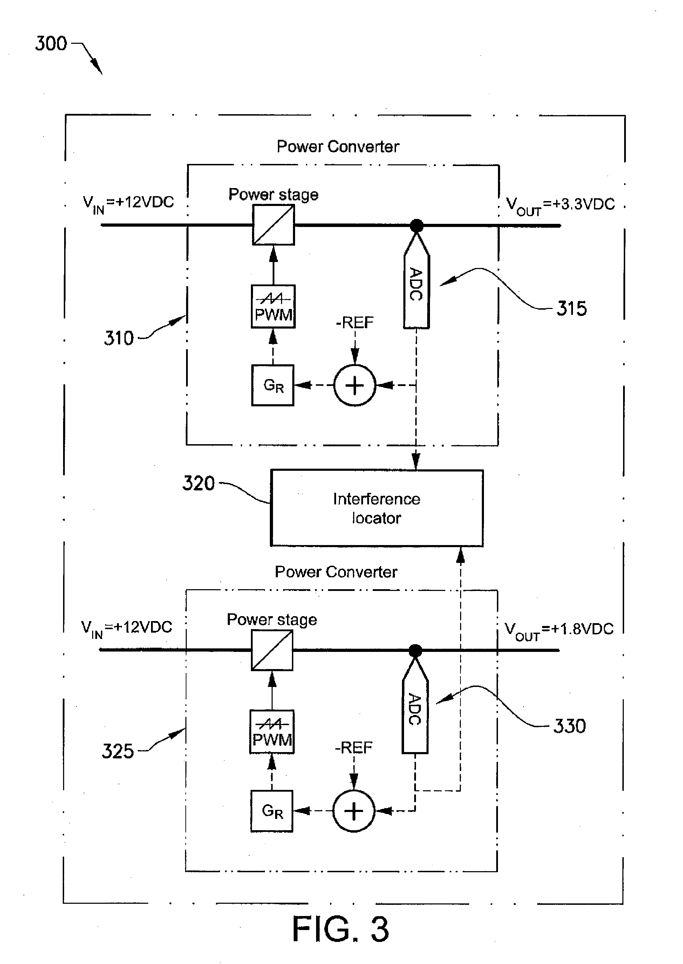

Fig 3 shows a first embodiment of an electronics device 300 of the invention. The embodiment 300 is a Printed Circuit Board, a PCB, which is one embodiment of the electronics device. The electronics device can also consist of or comprise two or more PCBs which are connected to each other

The PCB 300 comprises a number of power converters, two of which, 310, 325, are shown in fig 3. Again, the power converters are shown as DC-DC converters, but this is merely one embodiment of a power converter which may be used in the electronics device. In addition, some of the components of the power converters 310, 325 are shown in fig 3, although they are not referenced by reference numbers nor are they commented upon further here.

The electronics device also comprises a subsystem for locating sources of electromagnetic interference, in fig 3 shown as an interference locator 320. The interference locator 320 is in fig 3 shown as being located on the PCB 300, but it can in other embodiments also be a unit which is separate from the PCB 300, but connected to it.

The interference locator 320 is arranged to receive measurement data from the transducers 315, 330 of the power converters 310, 325. It should be pointed out that the measurement data which is received by the interference locator 320 is in most embodiments the "normal" measurement data from the transducers 315, 330, i.e. the measurements made by the transducers 315, 330 in their "normal" function in the power converters 310, 325, which makes the invention highly cost-efficient. An example of such a "normal" function for a transducer in a power converter is in a feedback loop which maintains a constant output voltage from the power converter.

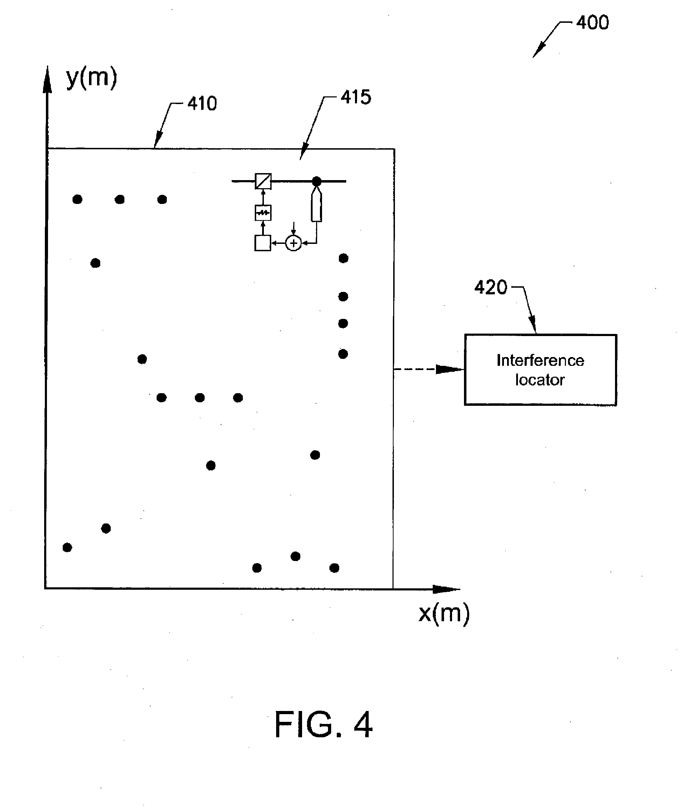

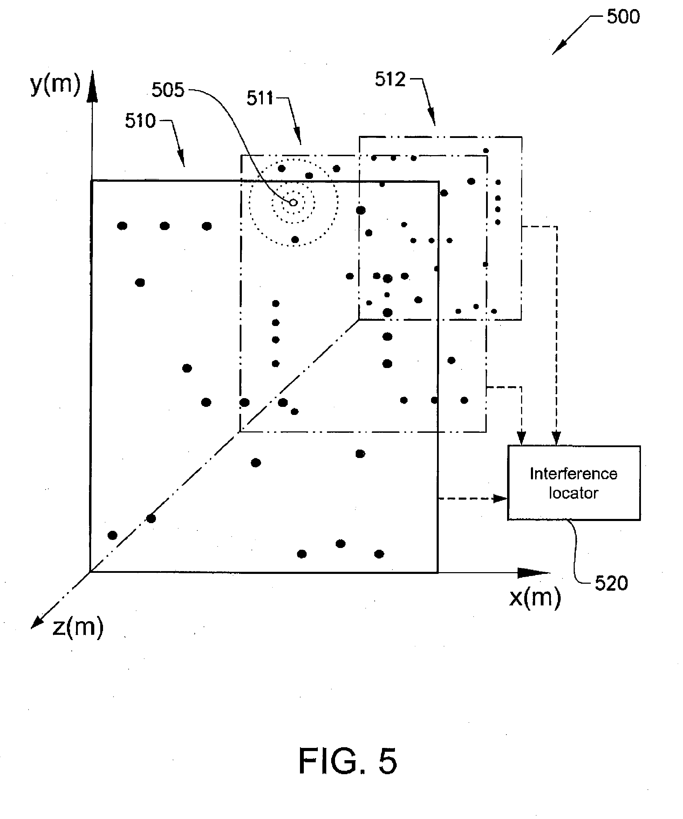

The interference locator 320 is arranged to use the measurement data from the transducers 315, 330 in order to locate sources of EMI, electromagnetic interference which are external or internal inside to the PCB 300. As realized by now by those skilled in the field, the exact mechanism used by the interference locator 320 in order to locate sources of EMI can vary between a large number of such mechanisms, some of which will be exemplified in this text. However, before such mechanisms are described, some further embodiments of the electronics device will be given, with reference to figs 4 and 5.

Fig 4 shows an embodiment of an electronics device 400 with a PCB 410, which is shown in fig 4 with a number of dots on it, with each dot representing one transducer connected to a power converter on the PCB 410, so that each dot also represents one transducer. The PCB 410 has twenty dots on it, which is a realistic example, due to the increasing number of power converters on present day PCBs. This is another feature which adds to the invention's usefulness: present day PCBs or other electronics devices usually have a large number of power converters, each of which has a transducer which can also be used as a transducer in an EMI locator. In fig 4, one of the power converters, shown as 415, has been drawn in its entirety, in order to show what the dots in the PCB 410 in fig 4 signify.

The electronics device 400 also comprises an interference locator 420, which receives measurement data from the transducers of the power converters on the PCB 410. In fig 4, the PCB 410 is drawn against an orthogonal x-y coordinate system, so that each transducer or dot in the PCB 410 can be assigned an unambiguous position with x-y coordinates. These coordinates are suitably either stored in the interference locator 420 initially, or they can, alternatively, be reported from the transducers along with the measurement data. The coordinates of a reporting transducer are suitably used by the interference locator when locating a source of EMI.

Fig 5 shows another embodiment of an electronics device 500. The electronics device 500 is shown as comprising three PCBs 510, 511, 512, which in this particular embodiment are arranged in parallel to each other. As indicated by means of dots on the PCBs 510, 511 and 512, each PCB incorporates a number of power converters, each of which has a transducer. The electronics device 500 also comprises an interference locator 520, here shown as being separate from the electronics device 500, but connected to it. In similarity to the embodiment of fig 4, the interference locator 520 either has the locations in the coordinate system x-y-z of each transducer stored initially, or the positions can be reported by the transducers continuously when reporting measured data, or once only.

In addition, fig 5 also shows a source of EMI 505, in fig 5 symbolically shown as a circle (as opposed to dots) with a number of concentric dashed rings around it, in order to symbolize the propagation of the EMI from the source of EMI 505.

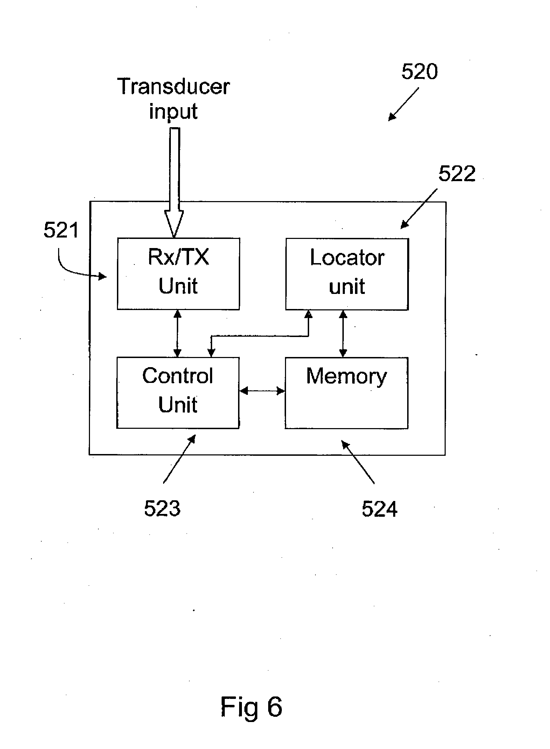

Turning now to an example of the nature of the interference locator 320, 420, 520 of figs 3-5, an example of such an embodiment is shown in fig 6. The interference locator shown in fig 6 is labeled 520, but can equally well serve as the interference locator 320 or 420 of the embodiments of figs 3 or 4.

As shown in fig 6, the interference locator 520 comprises a communications unit, shown as Rx/Tx unit 521. The communications unit 521 is the unit that receives the measurement data from the transducers of the power converters, and is also the unit that transmits commands etc to the transducers in those embodiments in which the transducers are arranged to be controlled by the interference locator 520. The interference locator 520 also comprises a control unit 523, which is the unit that controls the function of the interference locator 520, i.e. it controls the function of the other units of the interference locator 520. The interference locator 520 also comprises a memory unit 524, which can, for example, be used in order to store measurement data from the transducers of the power converters, and/or to store program code for the function of the control unit 523 etc.

In addition, the interference locator 520 also comprises a locator unit 522, which is the unit that processes the measurement data from the transducers of the power converters in order to locate sources of EMI, by means of e.g. determining the most likely location of sources of EMI.

In fig 6, the communications unit 521 is shown as being connected to the control unit 523. In such an embodiment, the control unit 523 forwards measurement data from the transducers of the power converters to the locator unit 522, while, in other embodiments, the communications unit can also be connected directly to both the control unit 523 and to the locator unit 522, as well as to the memory unit 524.

Regarding the measurement data which is supplied by the transducers of the power converters to the interference locator 520, in some embodiments of the electronics device, the transducers are arranged to continuously supply their measurement data to the interference locator 520, while, in other embodiments, the transducers are arranged to supply a time limited segment of measurement data at discrete points in time to the interference locator 520. In such embodiments, the transducers can, for example, be arranged to supply measurement data during a one second interval every minute. In some embodiments, the transducers are arranged to include a timestamp with each such time limited segment of measurement data, signifying when the measurement was made. In some embodiments, as mentioned, the measurement data supplied by the transducers is stored in the memory unit 524 for processing by the locator unit 522.

In other embodiments, the interference locator 520 is arranged to control the discrete points in time at which the transducers supply their measurement data, for example in order to decrease the real time data transmitted on a data bus Naturally, in such embodiments as well, the transducers may be arranged to include a timestamp with their measurement data, signifying when the measurement was made, and the measurement data supplied by the transducers may be stored in the memory unit 524 for processing by the locator unit 522.

As mentioned, the locator unit is arranged to process measurement data in order to locate sources of EMI. In order to facilitate this, in some embodiments, the interference locator 520, suitably by means of the memory unit 524, is supplied with a list of where the transducers of the power converters are located in the electronics device, suitably by means of coordinate systems such as those shown in figs 4 and 5.

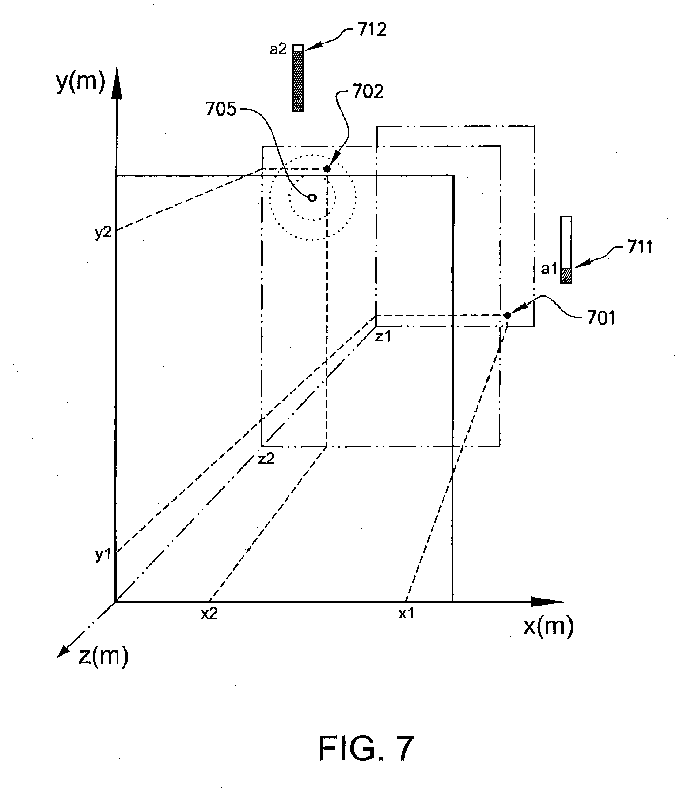

Turning now to how the location of sources of EMI are located by the locator unit 522 by means of the measurement data, an example of a principle will now be given with reference to fig 7. Those skilled in the art will realize that a wide variety of such mechanisms and principles are possible within the scope of the invention.

Fig 7 shows an example of a situation with two transducers 701, 702. The transducers are symbolically shown as dots in order to indicate their location in the coordinate system x-y-z, which was also shown in fig 5. Each transducer has a location defined by a set of x-y-z coordinates in the coordinate system. In fig 7, there is also shown an EMI source 705, indicated as a dot symbolically surrounded by rings, in order to show the interfering radiated emissions from the EMI source 705. The EMI source 705 also has a location which is determined by a set of x-y-z coordinates in the coordinate system, and these coordinates are what the interference locator 520 is arranged to determine, or least to approximate it as accurately as possible.

With reference to the example shown in fig 7, an EMI source such as the one 705 is located by the interference locator 520 in that it is arranged to determine the x-y-z coordinates of the EMI source 705 by weighing the amplitude of the signals in the measurement data by the location of the measurement data's corresponding transducer's, i.e. the positions in the x-y-z coordinate system of the transducers 701, 702.

The transducers 701, 702 will detect different interference signal amplitudes at a certain signal frequency. The different signal amplitudes are represented by level meters 711, 712 shown next to the transducers in fig 7. The x-y-z coordinates of the EMI source 705 can, for example, be determined by the interference locator 520 by multiplying each signal amplitude $a_1$, $a_2$ by the corresponding coordinates of the transducers 701, 702 along the x, y or z-axis, independently, i.e. one multiplication for each transducer and coordinate. In order to illustrate this concept, the procedure for determining the x-coordinate of the EMI source 705 will now be described: The x-coordinate of the EMI source 705 is determined by multiplying each signal amplitude $a_1$, $a_2$ by the x-coordinate $x_1$, $x_2$ of corresponding transducer 701, 702. The sum of the products is then divided by the sum of the signal amplitudes $a_1+a_2$ in order to determine the x-coordinate of the EM source 705. The same procedure is carried out for the y and z-axis, in order to find the coordinates along those axes' for the EMI source 705. A general expression for this procedure is as follows:

$$\bar{x} = \frac{1}{a}\sum_i a_i x_i \quad ; \quad a = \sum_i a_i$$

$$\bar{y} = \frac{1}{a}\sum_i a_i y_i \quad ; \quad a = \sum_i a_i$$

$$\bar{z} = \frac{1}{a}\sum_i a_i z_i \quad ; \quad a = \sum_i a_i$$

where $\bar{x}$, y and z represent the values for the determined coordinates along each axis x, y, z for the EMI source 705, and $x_i$, $y_i$ and $z_i$ represent the coordinates for transducer i along the x- y- and z-axis, respectively, and $a_i$ is the amplitude of the signal from transducer i.

In embodiments, the electronics device is also equipped with a list of how power terminals of the power converters are electrically connected to each other, for use in locating sources of electromagnetic interference. This is useful since interference from an EMI source can propagate through conductors (CE, Conducted Emission) as well as through air (RE, Radiated Emission). In the case of CE, information about how and if the power converters are connected to each other is useful, for example by information on how their power terminals are connected to each other.

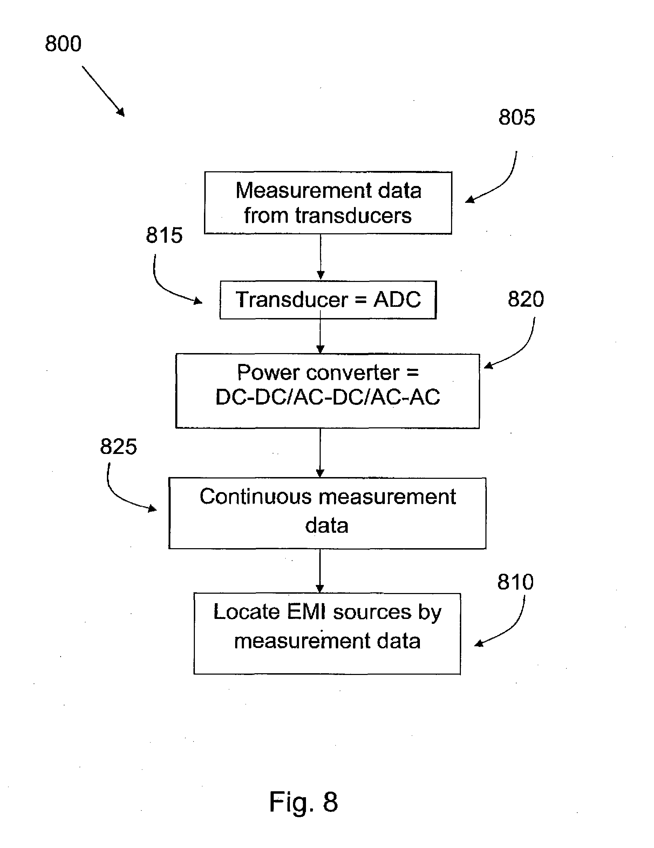

Fig 8 shows a schematic flowchart of a method 800. The method 800 is for use in an electronics device, and comprises, step 805, receiving measurement data on voltage and/or current from one or more transducers in one or more power converters on one or more circuit boards in the electronics device. According to the method 800, the measurement data is used in order to locate, step 810, sources of electromagnetic interference.

According to embodiments of the method 800, as shown in step 815, the power converters use Analogue to Digital Converters, ADCs as their transducers.

According to embodiments of the method 800, as shown in step 820, at least one of the power converters is a DC-DC converter.

According to embodiments of the method 800, as shown in step 820, at least one of the power converters is an AC-DC converter.

According to embodiments of the method 800, as shown in step 820, at least one of the power converters is an AC-AC converter.

According to embodiments of the method 800, as shown in step 825, the measurement data is continuously supplied from the transducers.

According to embodiments of the method 800, the measurement data is supplied during a time limited segment at discrete points in time.

According to embodiments of the method 800, a timestamp is included from the transducers with each time limited segment of measurement data, signifying when the measurement was made.

According to embodiments of the method 800, a timestamp is attached to each received measurement data.

According to embodiments of the method 800, the locations of the transducers in the electronics device are used for locating sources of electromagnetic interference.

Once a source of EMI has been located by a device or method as described above, the EMI source's location can either be transmitted to another unit in the same system or in another system, or it can be displayed on a display which is connected to the device.

The location of an EMI source is suitably activated by an operator who has noticed that there is a high likelihood of a source of EMI being present. Naturally, the "search" for a source of EMI can also yield a zero result, which is then communicated in the manner described above.

Embodiments of the invention are described with reference to the drawings, such as block diagrams and/or flowcharts. It is understood that several blocks of the block diagrams and/or flowchart illustrations, and combinations of blocks in the block diagrams and/or flowchart illustrations, can be implemented by computer program instructions. Such computer program instructions may be provided to a processor of a general purpose computer, a special purpose computer and/or other programmable data processing apparatus to produce a machine, such that the instructions, which execute via the processor of the computer and/or other programmable data processing apparatus, create means for implementing the functions/acts specified in the block diagrams and/or flowchart block or blocks.

These computer program instructions may also be stored in a computer-readable memory that can direct a computer or other programmable data processing apparatus to function in a particular manner, such that the instructions stored in the computer-readable memory produce an article of manufacture including instructions which implement the function/act specified in the block diagrams and/or flowchart block or blocks.

The computer program instructions may also be loaded onto a computer or other programmable data processing apparatus to cause a series of operational steps to be performed on the computer or other programmable apparatus to produce a computer-implemented process such that the instructions which execute on the computer or other programmable apparatus provide steps for implementing the functions/acts specified in the block diagrams and/or flowchart block or blocks..

In some implementations, the functions or steps noted in the blocks may occur out of the order noted in the operational illustrations. For example, two blocks shown in succession may in fact be executed substantially concurrently or the blocks may sometimes be executed in the reverse order, depending upon the functionality/acts involved.

In the drawings and specification, there have been disclosed exemplary embodiments of the invention. However, many variations and modifications can be made to these embodiments without substantially departing from the principles of the present invention. Accordingly, although specific terms are employed, they are used in a generic and descriptive sense only and not for purposes of limitation.

The invention is not limited to the examples of embodiments described above and shown in the drawings, but may be freely varied within the scope of the appended claims.

## Claims

1. An electronics device (300, 400, 500), comprising one or more circuit boards (410, 510, 511, 512) and a plurality of power converters (310, 325, 415) arranged on one or more of said circuit boards (410, 510, 511, 512), each power converter (310, 325, 415) comprising one or more transducers (315, 330) for measuring a voltage or a current in the power converter, the electronics device (300, 400, 500) additionally comprising a sub-system for locating sources of electromagnetic interference (320, 420, 520), the electronics device (300, 400, 500) being **characterized in that** the transducers (315, 330) of two or more of the power converters (310, 325, 415) are also connected to the sub-system for locating sources of electromagnetic interference (320, 420, 520) to supply it with measurement data, and **in that** the sub-system for locating sources of electromagnetic interference (320, 420, 520) is arranged to use the measurement data from the transducers (315, 330) in order to locate sources (505, 705) of electromagnetic interference.

2. The electronics device (300, 400, 500) of claim 1, in which the power converters (310, 325, 415) use Analogue to Digital Converters (315, 330) as their transducers.

3. The electronics device (300, 400, 500) of claim 1 or 2, in which said measured voltage or current in the power converter is also used as an output voltage or current from the power converter.

4. The electronics device (300, 400, 500) of any of claims 1-3, in which at least one of said power converters is a DC-DC converter.

5. The electronics device (300, 400, 500) of any of claims 1-3, in which at least one of said power converters is an AC-DC converter.

6. The electronics device (300, 400. 500) of any of claims 1-3, in which at least one of said power converters is an AC-AC converter.

7. The electronics device (300, 400, 500) of any of claims 1-6, in which the transducers (315, 330) are arranged to continuously supply said measurement data to the sub-system for locating sources of electromagnetic interference (320, 420, 520).

8. The electronics device (300, 400, 500) of any of claims 1-7, in which the transducers (315, 330) are arranged to supply a time limited segment of said measurement data at discrete points in time to the sub-system for locating sources of electromagnetic interference (320, 420, 520).

9. The electronics device (300, 400, 500) of any of claims 1-7, in which the transducers (315, 330) are arranged to include a timestamp with each time limited segment of measurement data, signifying when the measurement was made.

10. The electronic device (300, 400, 500) of any of claims 7-9, in which the sub-system for locating sources of electromagnetic interference (320, 420, 520) is arranged to control (523) the discrete points in time at which the transducers (315, 330) supply said measurement data.

11. The electronics device (300, 400, 500) of any of claims 1-10, being equipped with a list of where the transducers are located in the electronics device (300, 400, 500) for use in locating sources of electromagnetic interference.

12. The electronics device (300, 400, 500) of any of claims 1-11, being equipped with a list of how power terminals of the power converters are electrically connected to each other, for use in locating sources of electromagnetic interference.

13. The electronics device (300, 400, 500) of any of claims 1-12, in which the location of an artificial interference center is determined by weighing amplitude signals in said measurement data by their corresponding transducer's (315, 330) location in the electronics device (300, 400, 500).

14. A method (800) for use in an electronics device (300, 400, 500), comprising (805) receiving measurement data on voltage and/or current from one or more transducers (315, 330) in two or more power converters (310, 325, 415) on one or more circuit boards (410, 510, 511, 512) in the electronics device, the method (800) being **characterized in that** the measurement data is used in order to locate (810) sources of electromagnetic interference (320, 420, 520).

15. The method (800) of claim 14, according to which (815) the power converters (310, 325, 415) use Analogue to Digital Converters (315, 330) as their transducers.

16. The method (800) of claim 14, according to which (820) at least one of said power converters is a DC-DC converter.

17. The method (800) of claim 14, according to which (820) at least one of said power converters is an AC-DC converter.

18. The method (800) of claim 14, according to which (820) at least one of said power converters is an AC-AC converter.

19. The method (800) of any of claims 14-18, according to which (825) said measurement data is continuously supplied from said transducers (315, 330).

20. The method (800) of any of claims 14-18, according to which said measurement data is supplied during a time limited segment at discrete points in time.

21. The method (800) of any of claims 14-20, according to which a timestamp is included from the transducers with each time limited segment of measurement data, signifying when the measurement was made.

22. The method (800) of any of claims 14-21, according to which the locations of the transducers in the electronics device (300, 400, 500) are used for locating sources of electromagnetic interference.

**Patentansprüche**

1. Elektronikvoruchtung (300, 400, 500), umfassend eine oder mehrere Leiterplatten (410, 510, 511, 512) und eine Vielzahl von Leistungswandlern (310, 325, 415), die auf einer oder mehreren der Leiterplatten (410, 510, 511, 512) angeordnet sind, wobei jeder Leistungswandler (310, 325, 415) einen oder mehrere Umformer (315, 330) zur Messung einer Spannung oder eines Stroms im Leistungswandler umfasst, wobei die Elektronikvoruchtung (300, 400, 500) zusätzlich ein Teilsystem zur Lokalisierung von elektromagnetischen Störquellen (320, 420, 520) umfasst, wobei die Elektronikvoruchtung (300, 400, 500) **dadurch gekennzeichnet** ist, dass die Umformer (315, 330) von zwei oder mehr der Leistungswandler (310, 325, 415) auch mit dem Teilsystem zur Lokalisierung von elektromagnetischen Störquellen (320, 420, 520) verbunden sind, um sie mit Messdaten zu versorgen, und dass das Teilsystem zur Lokalisierung von elektromagnetischen Störquellen (320, 420, 520) dafür eingerichtet ist, die Messdaten von den Umformern (315, 330) zu verwenden, um elektromagnetische Störquellen (505, 705) zu lokalisieren.

2. Elektronikvoruchtung (300 400, 500) nach Anspruch 1, in der die Leistungswandler (310, 325, 415) Analog-Digital-Wandler (315, 330) als ihre Umformer verwenden.

3. Elektronikvoruchtung (300, 400, 500) nach Anspruch 1 oder 2, in der die gemessene Spannung oder der gemessene Strom im Leistungswandler auch als Ausgangsspannung oder -strom vom Leistungswandler verwendet wird.

4. Elektronikvoruchtung (300, 400, 500) nach einem der Ansprüche 1 bis 3, in der zumindest einer der Leistungswandler ein DC-DC-Wandler ist.

5. Elektronikvoruchtung (300, 400, 500) nach einem der Ansprüche 1 bis 3, in der zumindest einer der Leistungswandler ein AC-DC-Wandler ist.

6. Elektronikvoruchtung (300, 400, 500) nach einem der Ansprüche 1 bis 3, in der zumindest einer der Leistungswandler ein AC-AC-Wandler ist.

7. Elektronikvoruchtung (300, 400, 500) nach einem der Ansprüche 1 bis 6, in der die Umformer (315, 330) dafür eingerichtet sind, die Messdaten kontinuierlich an das Teilsystem zur Lokalisierung von elektromagnetischen Störquellen (320, 420, 520) zu liefern.

8. Elektronikvoruchtung (300, 400, 500) nach einem der Ansprüche 1 bis 7, in der die Umformer (315 330) dafür eingerichtet sind, ein zeitlich begrenztes Segment der Messdaten zu diskreten Zeitpunkten an das Teilsystem zur Lokalisierung von elektromagnetischen Störquellen (320, 420, 520) zu liefern.

9. Elektronikvoruchtung (300, 400, 500) nach einem der Ansprüche 1 bis 7, in der die Umformer (315, 330) dafür eingerichtet sind, einen Zeitstempel mit jedem zeitlich begrenzten Messdatensegment aufzunehmen, der angibt, wann die Messung erfolgt ist.

10. Elektronikvoruchtung (300, 400, 500) nach einem der Ansprüche 7 bis 9, in der das Teilsystem zur Lokalisierung von elektromagnetischen Störquellen (320, 420, 520) dafür eingerichtet ist, die diskreten Zeitpunkte, zu denen die Umformer (315, 330) die Messdaten liefern, zu steuern (523).

11. Elektronikvoruchtung (300, 400, 500) nach einem der Ansprüche 1 bis 10, die mit einer Liste ausgestattet ist, die besagt, wo sich die Umformer in der Elektronikvoruchtung (300, 400, 500) befinden, zur Verwendung bei der Lokalisierung von elektromagnetischen Störquellen.

12. Elektronikvoruchtung (300, 400, 500) nach einem der Ansprüche 1 bis 11, die mit einer Liste ausgestattet ist, die besagt, wie Leistungsanschlüsse der Leistungswandler elektrisch miteinander verbunden sind, zur Verwendung bei der Lokalisierung von elektromagnetischen Störquellen.

13. Elektronikvoruchtung (300, 400, 500) nach einem der Ansprüche 1 bis 12, in der die Position eines künstlichen Störungszentrums dadurch bestimmt wird, dass Amplitudensignale in den Messdaten durch die entsprechende Position ihrer Umformer (315, 330) in der Elektronikvorrichtung (300, 400, 500) gewichtet werden.

14. Verfahren (800) zur Verwendung in einer Elektronikvorrichtung (300, 400, 500), umfassend: (805) Empfangen von Messdaten bezüglich Spannung und/oder Strom von einem oder mehreren Umformern (315, 330) in zwei oder mehr Leistungswandlern (310, 325, 415) auf einer oder mehreren Leiterplatten (410, 510, 511, 512) in der Elektronikvorrichtung, wobei das Verfahren (800) **dadurch gekennzeichnet, dass** die Messdaten verwendet werden, um elektromagnetische Störquellen (320, 420, 520) zu lokalisieren (810).

15. Verfahren (800) nach Anspruch 14, in dem (815) die Leistungswandler (310, 325, 415) Analog-Digital-Wandler (315, 330) als ihre Umformer verwenden.

16. Verfahren (800) nach Anspruch 14, wobei (820) mindestens einer der Leistungswandler ein DC-DC-Wandler ist.

17. Verfahren (800) nach Anspruch 14, wobei (820) zumindest einer der Leistungswandler ein AC-DC-Wandler ist.

**18.** Verfahren (800) nach Anspruch 14, wobei (820) zumindest einer der Leistungswandler ein AC-AC-Wandler.

**19.** Verfahren (800) nach einem der Ansprüche 14 bis 18, wobei (825) die Messdaten von den Umformern (315, 330) kontinuierlich geliefert werden.

**20.** Verfahren (800) nach einem der Ansprüche 14 bis 18, wobei die Messdaten während eines zeitlich begrenzten Segments zu diskreten Zeitpunkten geliefert werden.

**21.** Verfahren (800) nach einem der Ansprüche 14 bis 20, wobei ein Zeitstempel von den Umformern mit jedem zeitlich begrenzten Messdatensegment aufgenommen wird, der besagt, wann die Messung erfolgt ist.

**22.** Verfahren (800) nach einem der Ansprüche 14 bis 21, wobei die Positionen der Umformer in der Elektronikvorrichtung (300, 400, 500) zur Lokalisierung von elektromagnetischen Störquellen verwendet werden.

**Revendications**

**1.** Dispositif électronique (300, 400, 500), comprenant une ou plusieurs cartes de circuit (410, 510, 511, 512) et une pluralité de convertisseurs de puissance (310, 325, 415) agencés sur une ou plusieurs desdites cartes de circuit (410, 510, 511, 512), chaque convertisseur de puissance (310, 325, 415) comprenant un ou plusieurs transducteurs (315, 330) pour mesurer une tension ou un courant dans le convertisseur de puissance, le dispositif électronique (300, 400, 500) comprenant en outre un sous-système destiné à localiser des sources d'interférences électromagnétiques (320, 420, 520), le dispositif électronique (300, 400, 500) étant **caractérisé en ce que** les transducteurs (315, 330) de deux convertisseurs de puissance ou plus (310, 325, 415) sont également connectés au sous-système destiné à localiser des sources d'interférences électromagnétiques (320, 420, 520) en vue de lui fournir des données de mesure, et **en ce que** le sous-système destiné à localiser des sources d'interférences électromagnétiques (320, 420, 520) est agencé de manière à utiliser les données de mesure en provenance des transducteurs (315, 330) en vue de localiser les sources (505, 705) d'interférences électromagnétiques.

**2.** Dispositif électronique (300, 400, 500) selon la revendication 1, dans lequel les convertisseurs de puissance (310, 325, 415) utilisent des convertisseurs « analogique à numérique » (315, 330) en tant que leurs transducteurs.

**3.** Dispositif électronique (300, 400, 500) selon la revendication 1 ou 2, dans lequel ladite tension mesurée ou ledit courant mesuré dans le convertisseur de puissance est également utilisé(e) en tant qu'une tension ou un courant de sortie en provenance du convertisseur de puissance.

**4.** Dispositif électronique (300, 400, 500) selon l'une quelconque des revendications 1 à 3, dans lequel au moins l'un desdits convertisseurs de puissance est un convertisseur CC-CC.

**5.** Dispositif électronique (300, 400, 500) selon l'une quelconque des revendications 1 à 3, dans lequel au moins l'un desdits convertisseurs de puissance est un convertisseur CA-CC.

**6.** Dispositif électronique (300, 400, 500) selon l'une quelconque des revendications 1 à 3, dans lequel au moins l'un desdits convertisseurs de puissance est un convertisseur CA-CA.

**7.** Dispositif électronique (300, 400, 500) selon l'une quelconque des revendications 1 à 6, dans lequel les transducteurs (315, 330) sont agencés de manière à fournir en continu lesdites données de mesure au sous-système destiné à localiser des sources d'interférences électromagnétiques (320, 420, 520).

**8.** Dispositif électronique (300, 400, 500) selon l'une quelconque des revendications 1 à 7, dans lequel les transducteurs (315, 330) sont agencés de manière à fournir un segment limité dans le temps desdites données de mesure à des points discrets dans le temps au sous-système destiné à localiser des sources d'interférences électromagnétiques (320, 420, 520).

**9.** Dispositif électronique (300, 400, 500) selon l'une quelconque des revendications 1 à 7, dans lequel les transducteurs (315, 330) sont agencés de manière à inclure une estampille temporelle avec chaque segment limité dans le temps de données de mesure, indiquant le moment où la mesure a été effectuée.

**10.** Dispositif électronique (300, 400, 500) selon l'une quelconque des revendications 7 à 9, dans lequel le sous-système destiné à localiser des sources d'interférences électromagnétiques (320, 420, 520) est agencé de manière à commander (523) les points discrets dans le temps auxquels les transducteurs (315, 330) fournissent lesdites données de mesure.

**11.** Dispositif électronique (300, 400, 500) selon l'une quelconque des revendications 1 à 10, lequel est équipé d'une liste des emplacements où les transducteurs sont situés dans le dispositif électronique (300, 400, 500) en vue d'une utilisation dans le cadre de la localisation de sources d'interférences électromagnétiques.

**12.** Dispositif électronique (300, 400, 500) selon l'une quelconque des revendications 1 à 11, lequel est équipé d'une liste indiquant comment les bornes d'alimentation des convertisseurs de puissance sont connectées électriquement les unes aux autres, en vue d'une utilisation dans le cadre de la localisation de sources d'interférences électromagnétiques.

**13.** Dispositif électronique (300, 400, 500) selon l'une quelconque des revendications 1 à 12, dans lequel l'emplacement d'un centre d'interférences artificielles est déterminé en pondérant des signaux d'amplitude dans lesdites données de mesure (315, 330) par leur emplacement de transducteur correspondant dans le dispositif électronique (300, 400, 500).

**14.** Procédé (800) destiné à être utilisé dans un dispositif électronique (300, 400, 500), comprenant les étapes ci-dessous consistant à : recevoir (805) des données de mesure sur une tension et/ou un courant en provenance d'un ou plusieurs transducteurs (315, 330) dans deux convertisseurs de puissance ou plus (310, 325, 415) sur une ou plusieurs cartes de circuit (410, 510, 511, 512) dans le dispositif électronique, le procédé (800) étant **caractérisé en ce que** les données de mesure sont utilisées en vue de localiser (810) des sources d'interférences électromagnétiques (320, 420, 520).

**15.** Procédé (800) selon la revendication 14, selon lequel (815) les convertisseurs de puissance (310, 325, 415) utilisent des convertisseurs « analogique à numérique » (315, 330) en tant que leurs transducteurs.

**16.** Procédé (800) selon la revendication 14, selon lequel (820) au moins l'un desdits convertisseurs de puissance est un convertisseur CC-CC.

**17.** Procédé (800) selon la revendication 14, selon lequel (820) au moins l'un desdits convertisseurs de puissance est un convertisseur CA-CC.

**18.** Procédé (800) selon la revendication 14, selon lequel (820) au moins l'un desdits convertisseurs de puissance est un convertisseur CA-CA.

**19.** Procédé (800) selon l'une quelconque des revendications 14 à 18, selon lequel (825) lesdites données de mesure sont fournies en continu à partir desdits transducteurs (315,330).

**20.** Procédé (800) selon l'une quelconque des revendications 14 à 18, selon lequel lesdites données de mesure sont fournies au cours d'un segment limité dans le temps à des points discrets dans le temps.

**21.** Procédé (800) selon l'une quelconque des revendications 14 à 20, selon lequel une estampille temporelle est incluse dans les transducteurs avec chaque segment limité dans le temps de données de mesure, indiquant l'instant où la mesure a été effectuée.

**22.** Procédé (800) selon l'une quelconque des revendications 14 à 21, selon lequel les emplacements des transducteurs dans le dispositif électronique (300, 400, 500) sont utilisés en vue de localiser des sources d'interférences électromagnétiques.

FIG. 1

FIG. 2

300

Power Converter

$V_{IN}$=+12VDC

Power stage

$V_{OUT}$=+3.3VDC

PWM

310

ADC

315

-REF

$G_R$

+

320

Interference locator

Power Converter

$V_{IN}$=+12VDC

Power stage

$V_{OUT}$=+1.8VDC

PWM

325

ADC

330

-REF

$G_R$

+

# FIG. 3

FIG. 4

FIG. 5

520

Transducer
input

522

521

Rx/TX
Unit

Locator
unit

Control
Unit

Memory

523

524

Fig 6

FIG. 7

800

805

| Measurement data from transducers |
|---|

815

| Transducer = ADC |
|---|

820

| Power converter = DC-DC/AC-DC/AC-AC |
|---|

825

| Continuous measurement data |
|---|

810

| Locate EMI sources by measurement data |
|---|

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Automatic Testing of the EMI Due to the Switching Frequency of the PWM Signal. **ATTAIANESE C et al.** IEEE TRANSACTIONS ON INDUSTRY APPLICATIONS. IEEE SERVICE CENTER, 01 March 2008, vol. 44, 644-649